**Europäisches Patentamt**

**European Patent Office**

**Office européen des brevets**

(19)

(11) Veröffentlichungsnummer : **0 123 872**
**B1**

(12) **EUROPÄISCHE PATENTSCHRIFT**

(45) Veröffentlichungstag der Patentschrift :
30.12.86

(21) Anmeldenummer : 84103101.6

(22) Anmeldetag : 21.03.84

(51) Int. Cl.⁴ : **H 05 K 10/00**, H 05 K 5/06,
H 01 R 9/26

(54) **Zenerbarriere.**

(30) Priorität : 02.04.83 DE 3312081

(43) Veröffentlichungstag der Anmeldung :
07.11.84 Patentblatt 84/45

(45) Bekanntmachung des Hinweises auf die Patenterteilung : 30.12.86 Patentblatt 86/52

(84) Benannte Vertragsstaaten :
CH DE FR GB LI NL

(56) Entgegenhaltungen :
DE-A- 2 753 145
DE-A- 2 942 258
DE-A- 3 037 783
DE-A- 3 120 583

(73) Patentinhaber : BROWN, BOVERI & CIE Aktiengesellschaft
Kallstadter Strasse 1
D-6800 Mannheim 31 (DE)

(72) Erfinder : Münch, Albert
Am Ledigsberg 8
D-6930 Eberbach (DE)
Erfinder : Schwarz, Gerhard
Zollerwaldstrasse 9
D-6936 Allemühl (DE)

(74) Vertreter : Kempe, Wolfgang, Dr. et al
c/o Brown, Boveri & Cie AG Postfach 351
D-6800 Mannheim 1 (DE)

EP 0 123 872 B1

**Beschreibung**

Die Erfindung betrifft eine eigensichere Zenerbarriere nach dem Oberbegriff des Anspruches 1.

Derartige Zenerbarrieren, die in explosionsgefährdeten Bereichen eingesetzt werden, trennen einen nicht eigensicheren Stromkreis von einem eigensicheren Stromkreis.

Eine Zenerbarriere der eingangs genannten Art ist aus der DE-OS-30 37 783 bekanntgeworden. Das Gehäuse, das die Schaltungsanordnung der Zenerbarriere aufnimmt, besteht aus zwei Gehäuseteilen, einem becherförmigen Gehäuseoberteil und einem das Gehäuseoberteil verschließenden Gehäuseunterteil, wobei beide Gehäuseteile dadurch miteinander verbunden werden, daß das Innere des Gehäuses mit Gießharz ausgegossen wird. Das Gehäuseunterteil nimmt eine Gewindebuchse auf, und mit Hilfe der Gewindebuchse kann eine Potentialausgleichsschiene gegen die Außenfläche des Gehäuseunterteils geschraubt werden. Zusätzlich wird ein Montagefuß an dem Gehäuse befestigt, der ein Aufschnappen der Zenerbarriere auf eine C-Profilschiene gestattet.

Die bekannte kompakt ausgestaltete Zenerbarriere besteht aus insgesamt drei Teilen, nämlich, dem Gehäuseoberteil, dem Gehäuseunterteil und dem Montagefuß. Zur Befestigung und Halterung der Potentialausgleichsschiene ist zusätzlich eine Gewindebuchse und eine mit dieser zusammenwirkende Schraube vorzusehen. Die Prüfung der Schaltungsanordnung, die in das Gehäuse eingebaut ist, muß vor dem Vergießen erfolgen, weswegen die Gefahr besteht, daß durch den Vergieß- und Aushärtvorgang selbst Änderungen und Beschädigungen der Schaltungsanordnung der Zenerbarriere bewirkt werden.

Demgemäß ist Aufgabe der Erfindung, eine Zenerdiode der eingangs genannten Art zu schaffen, bei der sowohl der Zusammenbau der Zenerbarriere als auch die für die Eigensicherheit erforderliche Prüfung einfach ausführbar sind, wobei insbesondere ermöglicht werden soll, daß die Prüfung der Zenerbarriere nach Abschluß aller Fertigungsschritte erfolgen kann.

Diese Aufgabe wird erfindungsgemäß durch die kennzeichnenden Merkmale des Anspruches 1 gelöst.

Der Vorteil der Erfindung besteht zunächst darin, daß insgesamt nur zwei Teile erforderlich sind, nämlich das eine, schalenförmig ausgebildete Gehäuseteil, und der Deckel, der mittels einer Schnappverbindung an dem Gehäuseteil befestigt wird.

Während, wie oben erwähnt, bei der Zenerdiode gemäß der DE-OS 30 37 783 die Prüfung der Schaltungsanordnung vor dem Vergießen erfolgen muß, was das Problem mit sich bringt, daß durch den Vergießvorgang selbst Änderungen und Beschädigungen der Zenerbarriere bewirkt werden können, kann bei der erfindungsgemäßen Ausgestaltung die Schaltungsanordnung zuerst vergossen und nach dem Vergießen, also im endgültig fertigen Zustand geprüft werden. Dies liegt daran, daß die Prüfstifte aus der Einziehung, also einem speziell ausgebildeten Teilbereich des Gehäuses, herausragen und dadurch ein Prüfen der Zenerdiode nach dem Vergießen des Gehäuseinnenraumes ermöglicht wird. Damit können durch den Gieß- und Aushärtvorgang bewirkte Beschädigungen festgestellt werden und nach dem Prüfvorgang sind nur noch die Prüfstifte einzugießen.

Zur Halterung des Deckels wird dieser einfach auf die offene Seite des Gehäuseteils aufgeschnappt. Dies erfolgt entweder nach dem Ausgießen des offenen Gehäuseteils oder vorher. Im letzteren Fall wird das Gehäuse nach dem Aufschnappen durch ein Loch im Deckel hindurch vergossen. In beiden Fällen aber wird die Halterung des Deckels dadurch bewirkt, daß die erfindungsgemäß am Deckel angeordnete bügelförmigen Vorsprünge von dem Gießharz umgeben sind und nach dem Aushärten des Gießharzes von diesem form- und kraftschlüssig festgehalten werden.

Die besonders vorteilhafte Ausgestaltung des Gehäuses mit den Mitteln zum Aufschnappen auf eine Tragschiene ist den Ansprüchen 3 bis 8 zu entnehmen. Dabei überdecken das Bodenteil des Gehäuseteils und der Deckel die Klemmen und nehmen diese zwischen sich. Der Klemmenaufnahmeraum, in dem die Klemmen angeordnet sind, wird durch die Verlängerungen des Bodenteils, den Deckel und je eine Begrenzungswand zum auszugießenden Raum hin begrenzt.

Gemäß dem kennzeichnenden Merkmal des Anspruches 6 bzw. 7 werden die einzelnen Klemmen gemäß den VDE-Vorschriften so gegeneinander getrennt, daß in jedem Fall die zulässigen Mindestluft- und Kriechstrecken eingehalten werden.

Ein weiterer Vorteil der Erfindung besteht in folgendem : Bei der DE-OS 30 37 783 ist die Potentialausgleichsschiene von unten gegen das Gehäuseunterteil angeschlagen. Bei der erfindungsgemäßen Ausgestaltung befindet sich in einer der Seitenwände des Gehäuseteils, nämlich in einer der Begrenzungswände zwischen dem Klemmenaufnahmeraum und dem auszugießenden Raum eine Nut, in die Potentialausgleichsschien eingelegt werden kann. Die Halterung der Potentialausgleichschiene erfolgt dann durch das Gießharz und den aufgesetzten Deckel. Eine zusätzliche Schraubenverbindung zur Halterung der Potentialausgleichsschiene ist nicht erforderlich.

Weitere Ausgestaltungen der Erfindung sind den kennzeichnenden Merkmalen der Ansprüche 9 und folgende zu entnehmen.

Danach sind die einzelnen federnden Vorsprünge gemäß dem kennzeichnenden Teil des Anspruches 9 unmittelbar an dem Gehäuseteil und dort an einer Schmalseitenfläche angeformt, wobei durch die Ausgestaltung der Vorsprünge ein Aufschnappen auf wahlweise eine C-Profiltragschiene oder auf eine Hut-Profiltragschiene ermöglicht ist.

Aus der DE-OS-31 20 583 sind die Merkmale, die die Ansprüche 9 bis 13 beinhalten, an sich bekannt. Jene Druckschrift aber beschreibt ein Gehäuse zur Aufnahme einer eigensicheren Zenerbarriere nicht.

Anhand der Zeichnung, in der ein Ausführungsbeispiel der Erfindung dargestellt ist, soll die Erfindung sowie weitere vorteilhafte Ausgestaltungen und Verbesserungen und weitere Vorteile näher erläutert und beschrieben werden. Es zeigt:

Figur 1 eine Seitenansicht einer Zenerbarriere, mit teilweise weggebrochenem Deckel,

Figur 2 eine weitere Seitenansicht der Zenerbarriere gemäß der Fig. 1, von der in Fig. 1 in der rückwärtigen Seite gesehen,

Figur 3 eine Schnittansicht gemäß der Linie III-III der Fig. 2 vor dem Ausgießen,

Figur 4 eine Schnittansicht gemäß der Linie III-III der Fig. 2 nach dem Ausgießen,

Figur 5 eine Schnittansicht gemäß der Linie V-V der Fig. 1,

Figuren 6-8 drei Aufsichten auf drei nebeneinander angeordnete Zenerbarrieren mit unterschiedlichen Anschlüssen der Potentialausgleichsschiene,

Figur 9 eine Aufsicht auf zwei an einer Wand befestigte Zenerbarrieren.

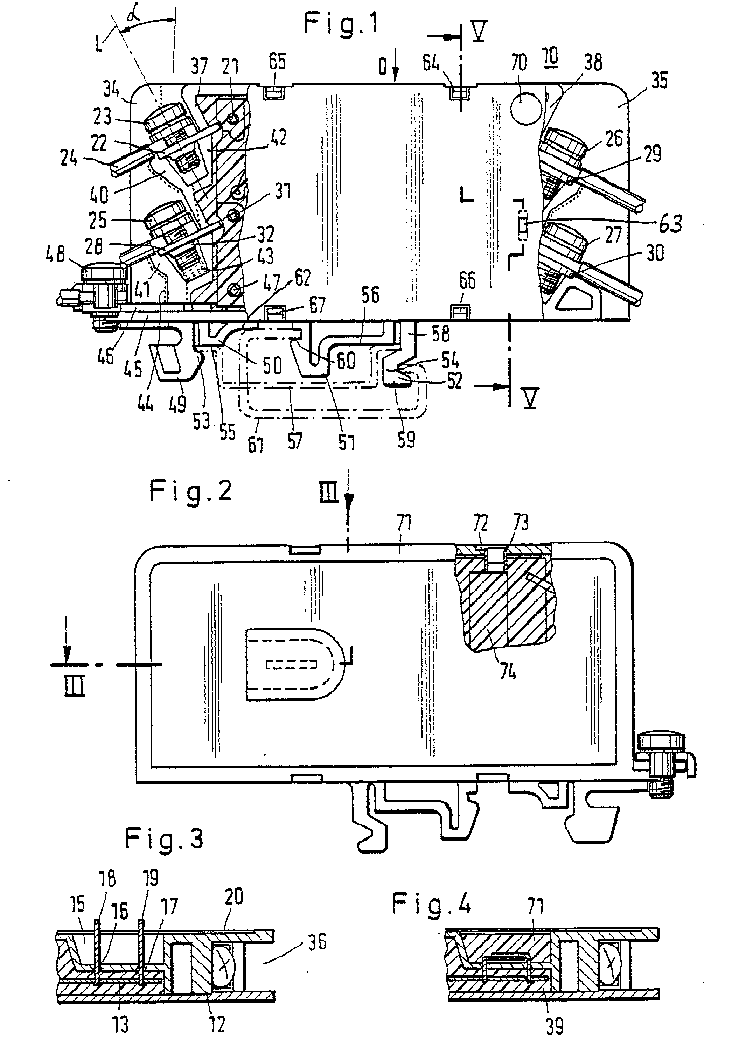

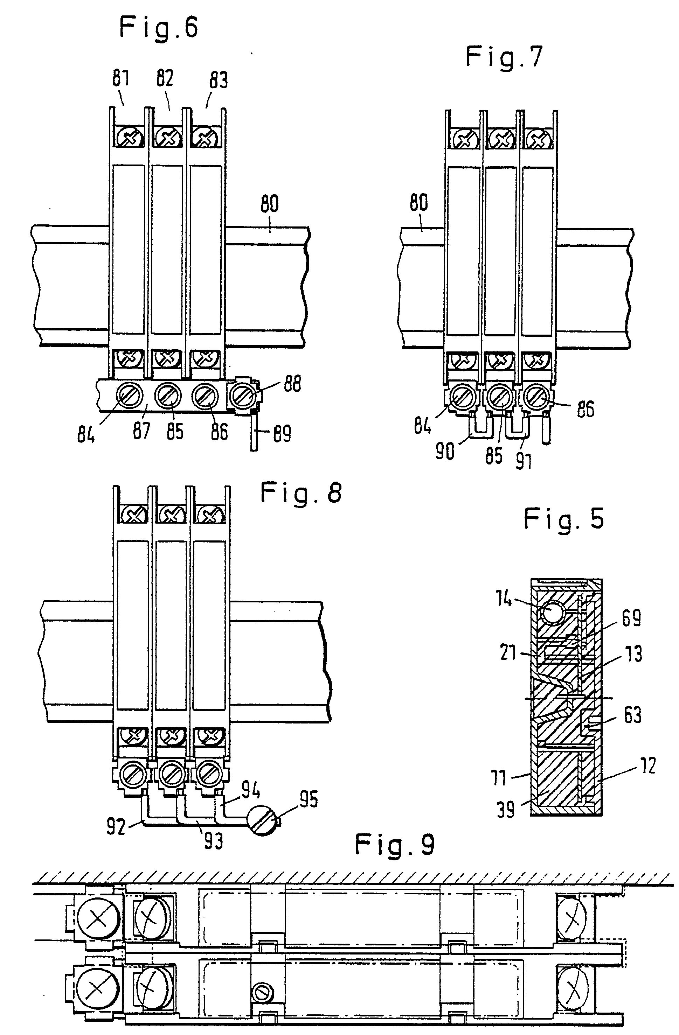

Wie aus der Fig. 1 und insbesondere auch aus der Fig. 5 hervorgeht, weist die erfindungsgemäße Zenerbarriere, die insgesamt mit der Bezugsziffer 10 bezeichnet ist, ein schalenförmig ausgebildetes Gehäuseteil 11 und einen Deckel 12 auf. Das schalenförmig ausgebildete Gehäuseteil 11 ist im Grundriß rechteckförmig und in Schmalbauweise ausgebildet, wobei das Gehäuseteil 11 nach einer Seite hin offen, wie aus Fig. 5 ersichtlich, und auf dieser Seite mittels des Deckels 12 verschlossen ist.

Das Gehäuseteil 11 nimmt eine Platine 13 auf, die die einzelnen Schaltungselemente der Schaltungsanordnung für die eigensichere Zenerbarriere trägt. Von diesen Bauelementen ist lediglich eine Sicherung 14 in der Zeichnung Fig. 5 zu sehen.

Der Gehäuseboden besitzt einen badewannenförmigen Einzug 15, der zwei in Abstand zueinander angeordnete Öffnung 16 und 17 aufweist, durch die an der Platine 13 befestigte Stifte 18 und 19 nach dem Einsetzen der Platine 13 hindurchgreifen und zwar soweit, daß sie die äußere Seitenfläche 20 des Gehäuseteiles 11 überragen. Diese Stifte 18 und 19 sind Prüfstifte, über die die elektrische Prüfung der Schaltungsanordnung erfolgen kann.

Mit der Platine 13 über U-förmige Anschlußbügel 21 verbunden ist die Anschlußfahne 22 einer Anschlußklemme 23, mittels der ein Anschlußleiter 24 mit der Schaltungsanordnung verbunden werden kann. Die Zenerbarriere besitzt insgesamt vier Klemmen 23, 25, 26 und 27, deren Anschlußfahnen 22, 28, 29 und 30 über dem U-Bügel 21 ähnliche U-Bügel 31 (nur der U-Bügel 31 der Anschlußklemme 25 ist zu sehen) mit der Platine verbunden sind. Die Anschlußfahnen 22, 28, 29 und 30 besitzen Durchzüge, von denen lediglich der Durchzug 32 der Anschlußfahne 28 bezeichnet ist, die ein Innengewinde aufweisen, durch das die Klemmschrauben 23, 25, 26 und 27 an den Anschlußfahnen festgeschraubt werden können.

Die Bodenebene des Gehäuseteils 11, die den Einzug 15 aufweist, besitzt an den beiden Schmalseiten Verlängerungen 34 und 35, die die Klemmen überdecken und auf dieser Seite den Klemmenaufnahmeraum begrenzen. Der Deckel 12 ist in seiner Außenkontur der Kontur des Gehäuseteiles 11 mit den Verlängerungen 34 und 35 angepaßt, so daß der Deckel 12 den Klemmenaufnahmeraum auf der anderen Seite begrenzt. Nach innen, also zum Inneren des Gehäuseteiles 11 hin, wird jeder Klemmenaufnahmeraum durch je eine Begrenzungswand 37 und 38 begrenzt, die gleichzeitig die Trenn- bzw. Dichtungswand für das Gießharz 39, mit dem das Gehäuse ausgegossen ist, bildet.

An dieser Begrenzungswand 37 und 38 schließen zusätzlich Trennwände 40 bzw. 41, die die Klemmschrauben umgeben und so mit den Begrenzungswänden 37 und 38 je einen Aufnahmeraum 42 bzw. 43 für die Klemmschrauben 23 und 25 bilden, dergestalt, daß der Winkel Alpha, den die Längsachse L jeder Klemmschraube mit der längeren Schmalseitenkante bildet, spitz ist, so daß die vier Klemmschrauben 23 bis 27 von oben, also von Pfeilrichtung 0 aus, betätigt werden können. Die Trennwände dienen dazu, die Kriechstrecken 44, die in der Fig. 1 punktiert dargestellt sind, ausreichend groß zu machen.

Im Bereich der unteren Schmalseitenkante, die durch eine Bodenabschlußwand 45 gebildet ist, ist eine Potential ausgleichsschiene 46 eingelegt, die sich nach innen in einen dem U-förmigen Bügel 31 entsprechenden U-förmigen Bügel 47 fortsetzt und mittels des U-förmigen Bügel 47 mit der Platine bzw. mit den elektrischen Bauelementen der Schaltungsanordnung der Platine 13 verbunden ist. Am äußeren Ende der Potentialausgleichsschiene 46 ist eine Klemmschraube 48 angebracht.

An der Außenfläche der Bodenwand 45 sind insgesamt vier Vorsprünge 49, 50, 51 und 52 angeformt. Der Vorsprung 49, auch erste Ausformung 49 genannt (wie alle Vorsprünge auch Ausformungen genannt werden), besitzt eine nach innen weisende Nase 53, der eine nach innen weisende, zu der Nase 53 hinweisende Nase 54 an dem die zweite Ausformung bildenden Vorsprung 52 entspricht. Die vierte Ausformung 50 besitzt eine erste Auflageebene 55, die in unmittelbarer Nähe zur Nase 53 liegt, und in gleicher Weise besitzt die dritte Ausformung 51 eine Auflagefläche 56, die im Bereich der Nase 54 liegt. Man erkennt, daß die beiden Nasen 53 und 54 zusammen mit den Auflageflächen 55 und 56 zur Halterung der freien Schenkelenden einer Hut-Profilschiene 57 dienen.

Die Nase 54 wird dadurch gebildet, daß an einen Bereich 58, der senkrecht zur Bodenwand 45 verläuft, sich ein V-förmiger Bereich 59 anschließt, dessen Spitze die Nase 54 bildet und dessen offene Seite in eine Richtung weist, die parallel zur Bodenwand verläuft.

An der dritten Ausformung 51 ist eine Nut 60 angeformt, die mit der offenen V-Seite der zweiten Ausformung 52 zur Aufnahme der Schenkelenden einer C-Profilschiene 61 zusammenwirkt. Die vierte Ausformung 50 besitzt zusätzlich zur Auflagefläche 55 eine weitere Auflagefläche 62, gegen die der eine Schenkel der Tragschiene 61 zum Anliegen kommt.

Die erste und dritte Ausformung 49 und 51 sind verhältnismäßig starr ausgebildet, wogegen die zweite Ausformung 52 federnd elastisch ausgebildet ist, so daß die Zenerbarriere bzw. das Gehäuse auf je einer der Tragschienen festgeschnappt werden kann.

Der Deckel 12 besitzt mehrere Vorsprünge 63, 64, 65, 66 und 67 ; mit den Vorsprüngen 64 bis 67 kann der Deckel am Gehäuseteil 11 festgerastet werden ; zwei Vorsprünge 63, von denen lediglich der in der Fig. 1 rechts liegende Vorsprung zu sehen ist, sind bügelförmig ausgebildet und dringen ins Innere des Gießharzes 39 ein, so daß das Gießharz die Vorsprünge vollständig umgibt und dadurch den Deckel 12 formschlüssig festhält.

Die Montage der Zenerbarriere bzw. der Zusammenbau verläuft wie folgt :

Zunächst wird in die offene Breitseite des Gehäuseteils 11 die Platine 13 eingelegt, wobei die Platine auf in der Zeichnung nicht näher dargestellten Gehäusevorsprüngen am Gehäuseteil 11 sowie auf Erweiterungen an den Bügeln 21, 31 bzw. 47 aufliegt. Die Bügel 21 liegen zur weiteren Abstützung auf der Innenfläche der Seitenwand auf, wie in Fig. 5 bei dem Bügel 21 deutlich zu sehen ist. Dabei greifen die mit der Platine verbundenen Stifte 18 und 19 durch die beiden Öffnungen 16 und 17 hindurch. Danach wird das Gehäuseteil 11 mit der eingesetzten Platine 13 ausgegossen und der Deckel 12 aufgesetzt, bevor das Gießharz ausgehärtet ist. Es besteht natürlich auch die Möglichkeit, ein Loch (siehe Loch 70) im Deckel (12) vorzusehen, durch welches nach Aufschnappen des Deckels (12) an den Aufschnappstellen 64 bis 67 das Gießharz eingegossen werden kann. Nach Aushärten des Gießharzes wird über die beiden Anschluß- bzw. Prüfstifte 18 und 19 die Schaltungsanordnung der Zenerbarriere geprüft, die Stifte 18 und 19 werden, wie aus Fig. 4 ersichtlich ist, umgebogen, wobei darauf zu achten ist, daß die beiden Stifte 18 und 19 in elektrisch leitender Verbindung miteinander sind und danach wird der Einzug 15 mit Gießharz 71 zugegossen. Die Zenerbarriere 10 wird also geprüft, nachdem die Zenerbarriere fertig vergossen und fertig ausgebildet ist.

Nachzutragen ist noch, daß auf der der Bodenfläche bzw. der Bodenwand 45 gegenüberliegenden Stirnwand 71 eine Öffnung 72 vorgesehen ist, an die sich ein Führungsring 73 anschließt bzw.

von der Öffnung 72 umgeben ist, welcher Führungsring 73 auf einem verstellbarem Schaltelement 74 aufliegt. Der Führungsring 73 dient zum Abdichten desjenigen, als Justiereinrichtung dienenden, verstellbaren Schaltelementes 74. Dieses muß nämlich nach dem Zusammenbau der Zenerbarriere und nach dem Ausgießen betätigt werden, so daß die Abdichtung durch den Führungsring 73 erforderlich ist.

Die Figuren 6 bis 8 zeigen unterschiedliche Zusammenschaltungen der Potentialschiene mehrerer Zenerbarrieren. Man erkennt auf einer Hut-Profiltragschiene 80, die der Hut-Profiltragschiene 57 der Fig. 1 entspricht, drei nebeneinander aufgeschnappte Zenerbarrieren 81, 82 und 83. Die Anschlußklemmen 84 bis 86 sind mittels einer Stromsammelschiene 87 gekuppelt, an derem einen Ende eine Anschlußklemme 88 für einen Anschlußleiter 89 angeformt bzw. befestigt ist.

Bei der Ausgestaltung der Fig. 7 werden die einzelnen Anschlußklemmen 84 bis 86 mittels U-förmig gebogener Leiteranschlußstücke 90 und 91 miteinander verbunden, wogegen in der Ausgestaltung der Fig. 8 an die einzelnen Anschlußklemmen 84 bis 86 Anschlußleiter 92 bis 94 angeschlossen sind, die miteinander mittels einer Verbindungsklemme 95 verbunden sind. An diese Verbindungsklemme 95 kann dann ein weiterer Anschluß- oder Erdungsleiter angeschlossen werden.

**Patentansprüche**

1. Eigensichere Zenerbarriere, mit einem zur Aufnahme der auf einer Leiterplatte aufgebrachten Schaltungsanordnung der Zenerbarriere dienenden Gehäuse, an dem Mittel zum Aufschnappen auf einer Normprofiltragschiene, Anschlußklemmen und eine Potentialausgleichsschiene angebracht sind und das mit Gießharz ausgegossen und mit einer Abschlußplatte (Deckel) verschlossen ist und das schalenförmig in Schmalbauweise ausgebildet ist, dadurch gekennzeichnet, daß das Gehäuse ein nach einer Breitseite offenes Gehäuseteil (11) und die Abschlußplatte (12), die an einer ihrer Seiten Vorsprünge (63) aufweist, umfaßt, daß auf das offene Gehäuseteil (11) die Abschlußplatte (12) aufgesetzt ist, wobei nach dem Ausgießen des Gehäuseteils mit Gießharz die Vorsprünge (63) in das Gießharz eintauchen, von Gießharz umflossen und nach Aushärten von dem Gießharz formschlüssig gehalten sind, und daß an der Außenfläche der Breitseite des Gehäuseteils (11) eine Einziehung (15) vorgesehen ist, die gegenüber der Außenfläche vertieft liegt und durch die hindurch Prüfanschlußstifte (18, 19) nach außen herausragen, wobei die Einziehung nach Umbiegen der Prüfanschlußstifte in eine parallel zur Einziehung verlaufende Stellung mit Gießharz ausgegossen ist.

2. Zenerbarriere nach Anspruch 1, dadurch gekennzeichnet, daß die an der Abschlußplatte (12) vorgesehenen Vorsprünge (63) bügelförmig ausgebildet sind.

3. Zenerbarriere nach einem der vorigen Ansprüche, dadurch gekennzeichnet, daß das Gehäuse quaderförmig mit rechteckiger Kontur ausgebildet ist, daß die Anschlußklemmen (23, 25, 26, 27) an den kürzeren Schmalseitenflächen und die Mittel (49 bis 56 und 62) zum Aufschnappen an einer der längeren Schmalseitenfläche (Bodenfläche) angeordnet sind.

4. Zenerbarriere nach einem der vorigen Ansprüche, dadurch gekennzeichnet, daß die Breitseitenwand des Gehäuseteils (11) mit Verlängerungen· (34, 35) und die Abdeckplatte (12) die Anschlußklemmen (23...) überdecken und zwischen sich nehmen und so einen Klemmenaufnahmeraum (36) bilden.

5. Zenerbarriere nach Anspruch 4, dadurch gekennzeichnet, daß jeder Klemmenaufnahmeraum (36) nach innen zum ausgegossenen Raum hin durch eine Begrenzungswand (42) begrenzt ist.

6. Zenerbarriere nach Anspruch 5, dadurch gekennzeichnet, daß zusätzlich in jedem Klemmenaufnahmeraum (36) zwei schräg nach außen verlaufende Trennwandteile (40, 41) vorgesehen sind, die die obere Anschlußklemme (23, 26) von der unteren Klemme (25, 27) in jedem Klemmenaufnahmeraum und darüberhinaus die untere Anschlußklemme (25) von der Potentialausgleichsschiene (46) trennen.

7. Zenerbarriere nach Anspruch 6, dadurch gekennzeichnet, daß die Anschlußklemmen einen spitzen Winkel (Alpha) zu einer Senkrechten (L) zur Bodenwand hin bilden.

8. Zenerbarriere nach Anspruch 7, dadurch gekennzeichnet, daß die Trennwandabschnitte (37, 38) schrägverlaufende Aufnahmeöffnungen (42, 43) für die Klemmschrauben der Anschlußklemmen begrenzen.

9. Zenerbarriere nach einem der vorigen Ansprüche, dadurch gekennzeichnet, daß eine erste und eine zweite Ausformung (49, 52), von denen die zweite Ausformung (52) federnd ausgebildet ist, je mit einer jeweils zur anderen hin weisenden Nase (53, 54) versehen sind, dergestalt, daß die beiden Nasen (53, 54) zur Hintergreifung der freien Schenkel einer Hut-Profiltragschiene (57) ausgebildet und geeignet sind, daß eine zwischen der ersten und zweiten Ausformung (49, 52) befindliche dritte Ausformung (51) vorgesehen ist, die eine Nut (60) aufweist, und daß die federnd ausgebildete zweite Ausformung (52) zusätzlich zur Nase (54) eine weitere, außenliegende Nut aufweist, dergestalt, daß die Nut und die weitere Nut die freien Schenkel einer C-Profiltragschiene (61) aufnehmen.

10. Zenerbarriere nach Anspruch 9, dadurch gekennzeichnet, daß die zweite Ausformung (52) einen senkrecht zur Schmalseite (Bodenseite) verlaufenden Abschnitt (58) und einen daran anschließenden, annähernd quer verlaufenden V-förmigen Abschnitt (59) aufweist, der mit seiner V-Spitze die Nase (54) und mit seiner V-Öffnung die weitere Nut bildet.

11. Zenerbarriere nach einem der Ansprüche 8 bis 10, dadurch gekennzeichnet, daß zwischen der ersten Ausformung (49) und der dritten Ausformung (51) eine vierte Ausformung (50) mit einer Auflagefläche (55) für die Flachseite des einen Schenkels der Hut-Profiltragschiene (57) und zwischen der zweiten und dritten Ausformung (52, 51) eine weitere Auflagefläche (56) für die Flachseite des anderen Schenkels der Hut-Profiltragschien (57) vorgesehen sind, welche Auflageflächen derart den Nasen (53, 54) zugeordnet sind, daß sie mit diesen zum Festklemmen der Schenkel der Hut-Profiltragschiene (57) dienen.

12. Zenerbarriere nach Anspruch 11, dadurch gekennzeichnet, daß die der zweiten Ausformung (52) zugeordnete weitere Auflagefläche (56) an der dritten Ausformung (51) einstückig anschließt.

13. Zenerbarriere nach Anspruch 12, dadurch gekennzeichnet, daß die der ersten Ausformung (49) zugeordnete vierte Ausformung (50) eine Auflageebene für den in die Nut (60) an der dritten Ausformung (51) eingreifenden Schenkel der C-Profiltragschiene (61) aufweist.

**Claims**

1. Intrinsically safe Zener barrier, with a housing which serves for receiving the Zener barrier circuit arrangement on a printed circuit board and to which are attached means of snapping it on a standard sectional supporting rail, connecting terminals and a potential-equalizing bar, and which is filled with cast resin and closed by means of a closing plate (cover) and is made shell-shaped in a narrow design, characterized in that the housing comprises a housing part (11), open towards a wide side, and the closing plate (12) which has projections (63) on one of its sides, in that the closing plate (12) is attached onto the open housing part (11), and, after the housing part has been filled with cast resin, the projections (63) penetrate into the cast resin, are surrounded by cast resin and, after hardening, are held positively by the cast resin, and in that on the outer face of the wide side of the housing part (11) there is a retracted portion (15) which is recessed relative to the outer face and through which test connection pins (18, 19) project outwards, the retracted portion being filled with cast resin after the test connection pins have been bent round into a position extending parallel to the retracted portion.

2. Zener barrier according to Claim 1, characterized in that the projections (63) provided on the closing plate (12) are made stirrup-shaped.

3. Zener barrier according to one of the preceding claims, characterized in that the housing is made cuboid with a rectangular contour, and in that the connecting terminals (23, 25, 26, 27) are arranged on the shorter narrow-side faces, and the snapping-on means (49 to 56 and 62) are arranged on one of the longer narrowside faces (bottom face).

4. Zener barrier according to one of the preceding claims, characterized in that the wide side wall of the housing part (11), with extensions (34, 35), and the cover plate (12) mask and receive between them the connecting terminals (23, etc.) and thus form a terminal-receiving space (36).

5. Zener barrier according to Claim 4, characterized in that each terminal-receiving space (36) is delimited inwards, towards the filled space by a limiting wall (42).

6. Zener barrier according to Claim 5, characterized in that there are additionally, in each terminal-receiving space (36), two partition wall parts (40, 41) which extend obliquely outwards and which separate the upper connecting terminal (23, 26) from the lower terminal (25, 27) in each terminal-receiving space and furthermore separate the lower connecting terminal (25) from the potential-equalizing bar (46).

7. Zener barrier according to Claim 6, characterized in that the connecting terminals form an acute angle (Alpha) relative to a vertical line (L) towards the bottom wall.

8. Zener barrier according to Claim 7, characterized in that the partition wall portions (37, 38) delimit receiving orifices (42, 43) which extend obliquely for the clamping screws of the connecting terminals.

9. Zener barrier according to one of the preceding claims, characterized in that a first and a second lug (49, 52), of which the second lug (52) is resilient, are each provided with a nose (53, 54) pointing towards the other, in such a way that the two noses (53, 54) are designed and are suitable for engaging behind the free legs of a hat-shaped sectional supporting rail (57), in that there is a third lug (51) which is located between the first and second lugs (49, 52) and which has a groove (60), and in that the resilient second lug (52) has, in addition to the nose (54), a further outer groove, so that the groove and the further groove receive the free legs of a C-shaped sectional supporting rail (61).

10. Zener barrier according to Claim 9, characterized in that the second lug (52) has a portion (58), extending perpendicularly relative to the narrow side (bottom side), and an approximately transverse V-shaped portion (59) which adjoins the latter and which forms the nose (54) with the tip of the V and the further groove with the aperture of the V.

11. Zener barrier according to one of Claims 8 to 10, characterized in that between the first lug (49) and the third lug (51) there is a fourth lug (50) with a bearing face (55) for the flat side of one leg of the hat-shaped sectional supporting rail (57), and between the second and third lugs (52, 51) there is a further bearing face (56) for the flat side of the other leg of the hatshaped sectional supporting rail (57), these bearing faces being assigned to the noses (53, 54) in such a way that they serve, together with these, for clamping the legs of the hat-shaped sectional supporting rail (57).

12. Zener barrier according to Claim 11, characterized in that the further bearing face (56) assigned to the second lug (52) is joined integrally to the third lug (51).

13. Zener barrier according to Claim 12, characterized in that the fourth lug (50) assigned to the first lug (49) has a bearing plane for that leg of the C-shaped sectional supporting rail (61) which engages into the groove (60) in the third lug (51).

## Revendications

1. Barrière de Zener autoprotégée comprenant un boîtier qui sert au logement du circuit de la barrière de Zener imprimé sur une plaquette, boîtier sur lequel sont fixés des moyens pour encliquetage sur un rail porteur de profil normalisé, des bornes de connexion et un rail d'équilibrage de potentiel et qui est rempli de résine de moulage et fermé par une plaque de fermeture (couvercle) et réalisé en forme de cuvette de structure compacte, caractérisée par le fait que ledit boîtier comprend une partie (11) ouverte sur la largeur et le couvercle 12, lequel présente sur ses côtés des ergots (63), que sur la partie (11) ouverte est monté le couvercle (12), et après le remplissage de la partie boîtier avec de la résine, les ergots (63) pénètrent dans cette résine, sont noyés dans ladite résine et après son durcissement deviennent solidaires de la résine, et que sur la surface extérieure de la largeur de la partie (11) du boîtier est prévu un évidement (15) qui est creusé dans la surface extérieure et à travers lequel des broches de connexion (18, 19) destinées au contrôle font saillie vers l'extérieur, ledit évidement étant rempli de résine après que les broches de connexion de contrôle aient été repliées dans une position s'étendant parallèlement audit évidement.

2. Barrière de Zener selon la revendication 1, caractérisée par le fait que les ergots (63) prévus sur le couvercle (12) sont réalisés en forme d'étriers.

3. Barrière de Zener selon l'une quelconque des revendications précédentes, caractérisée par le fait que le boîtier est réalisé en forme de parallélépipède à contour rectangulaire, que les bornes de connexion (23, 25, 26, 27) sont montées sur les surfaces plus petites des côtés étroits et que les moyens (49 à 56 et 62) pour encliquetage sont disposés sur l'une des surfaces plus grandes du côté étroit (surface du fond).

4. Barrière de Zener selon l'une quelconque des revendications précédentes, caractérisée par le fait que la paroi du côté large de la partie (11) du boîtier comportant des prolongements (34, 35) et le couvercle (12) recouvrent les bornes de connexion (23...) et s'imbriquent l'un dans l'autre, formant ainsi un espace (36) pour le logement des bornes.

5. Barrière de Zener selon la revendication 4, caractérisée par le fait que chaque espace (36) pour le logement des bornes est délimité vers l'intérieur en direction de l'espace rempli de résine par une paroi de séparation (42).

6. Barrière de Zener selon la revendication 5, caractérisée par le fait qu'en outre, dans chaque espace (36) prévu pour le logement des bornes, sont prévus deux éléments de paroi de séparation (40, 41) s'étendant obliquement vers l'extérieur, qui séparent la borne de connexion supérieure (23, 26) de la borne inférieure (25, 27) dans chaque espace réservé au logement des bornes et séparent en outre la borne de connexion inférieure (25) du rail (46) d'équilibrage du potentiel.

7. Barrière de Zener selon la revendication 6, caractérisée par le fait que les bornes de connexion forment un angle aigu (α) avec une ligne perpendiculaire (L) à la paroi constituant le fond.

8. Barrière de Zener selon la revendication 7, caractérisée par le fait que les sections (37, 38) de la paroi de séparation délimitent des orifices (42, 43) de réception s'étendant obliquement destinés aux vis de serrage des bornes de connexion.

9. Barrière de Zener selon l'une quelconque des revendications précédentes, caractérisée par le fait qu'une première et une seconde saillies (49, 52), dont la seconde saillie (52) est élastique, sont munies chacune d'une dent (53, 54) orientée vers l'autre saillie et conformées de telle sorte que les deux dents (53, 54) sont capables de saisir les ailes libres d'un rail porteur à profil en chape (57) et qu'une troisième saillie (51) se trouvant entre la première et la seconde saillie (49, 52) est prévue, qui présente une rainure (60) et que la deuxième saillie élastique (52) présente en plus de la dent (54) une autre rainure située à l'extérieur, conformée de telle sorte que la rainure et l'autre rainure reçoivent les ailes libres d'un rail porteur (61) à profil en C.

10. Barrière de Zener selon la revendication 9, caractérisée par le fait que la seconde saillie (52) présente une section (58) s'étendant perpendiculairement au côté étroit (côté du fond) et une autre section (59) en forme de V faisant suite à la première et s'étendant sensiblement transversalement, constituant avec sa pointe en V la dent (54) et avec son ouverture V l'autre rainure.

11. Barrière de Zener selon l'une quelconque des revendications 8 à 10, caractérisée par le fait qu'entre la première saillie (49) et la troisième saillie (51) sont prévues une quatrième saillie (50) comportant une surface d'appui (55) pour le côté plat de l'une des ailes du rail porteur à profil en chape et, entre la seconde et la troisième saillie (52, 51), une autre surface d'appui (56) pour le côté plat de l'autre aile du rail porteur à profil en chape (57), lesquelles surfaces d'appui sont associées aux ergots (53, 54) de telle sorte qu'elles servent conjointement avec ces ergots au serrage de fixation des ailes du rail (57) à profil en chape.

12. Barrière de Zener selon la revendication 11, caractérisée par le fait que l'autre surface d'appui (56) associée à la seconde saillie (52) se raccorde à la troisième saillie (51) de manière à ne constituer qu'une seule pièce avec celle-ci.

13. Barrière de Zener selon la revendication 12, caractérisée par le fait que la quatrième saillie (50) associée à la première saillie (49) présente un plan d'appui pour le rail (61) à profil en C qui s'engage dans la rainure (60) pratiquée sur la troisième saillie (51).

0 123 872

Fig.1

Fig.2

Fig.3

Fig.4

Fig.6

Fig.7

Fig.8

Fig.5

Fig.9